# EUROPEAN PATENT SPECIFICATION

(11) **EP 4 018 473 B1**
(45) Date of publication and mention of the grant of the patent: **03.07.2024**
(21) Application number: 20855227.3
(22) Date of filing: 19.08.2020
(51) Int. Cl.: H01L 21/683, H01L 21/67, C23C 14/50, C23C 16/458, H01L 21/687, C23C 14/34

(54) **SYSTEMS AND METHODS FOR A LIFT AND ROTATE WAFER HANDLING PROCESS**
SYSTEME UND VERFAHREN FÜR EIN HUB- UND DREHWAFERHANDHABUNGSVERFAHREN
SYSTÈMES ET PROCÉDÉS POUR UN PROCESSUS DE LEVAGE ROTATIF DE MANIPULATION DE TRANCHES

(30) Priority: 19.08.2019 US 201962888735 P
(43) Date of publication of application: 29.06.2022
(73) Proprietor: Oem Group, LLC, Gilbert, Arizona 85233 (US)
(72) Inventor: LARIVIERE, Marc A., Gilbert, Arizona 85233 (US); TRANG, Brendan V., Gilbert, Arizona 85233 (US); CORRERA, Michael S., Gilbert, Arizona 85233 (US); FORGEY, Christian K., Gilbert, Arizona 85233 (US); RIOS REYES, Juan M., Gilbert, Arizona 85233 (US)
(74) Representative: IP Trust
(86) International application number: PCT/US2020/047057
(87) International publication number: WO 2021/034968

(56) References cited:
- EP-A2- 0 669 642
- CN-B- 104 576 495
- JP-A- 2007 119 794
- JP-A- 2010 192 515
- JP-A- 2010 192 515
- KR-A- 20130 062 233
- US-A- 6 001 234
- US-A1- 2004 099 219
- US-A1- 2007 261 726

## Description

### CROSS-REFERENCE TO RELATED APPLICATIONS

This is a Patent Cooperation Treaty application that claims benefit to U.S. provisional application serial number 62/888,735 filed on August 19, 2019.

### FIELD

The present disclosure generally relates to systems and methods for handling wafers during a sputtering process; and in particular, to a mechanical assembly for linear and rotational handling of a wafer substrate under high vacuum.

### BACKGROUND

The manufacturing of electronic substrates involves sputtering methods which may include the deposition of thin films and coatings of material on an atomic scale onto thin slices of semiconductor materials in a vacuum environment. These processes require high manufacturing standards to ensure compliance with requirements related to proper film coating thickness and uniformity. In the past, wafers have been held within a wafer processing chamber over a sputtering target or sputtering gun and remained stationary while particles were ejected at the wafer, causing issues with a lack of film uniformity across the wafer. These static arrangements also made wafer height adjustments for short or long throw sputtering cumbersome, as shield spacers must be manually replaced in order to alter wafer height. As such, a non-static method of wafer handling is desirable in order to meet the stringent standards of wafer manufacturing.

Prior art is disclosed in the documents JP2010-192 515A and EP 669 642-A2.

It is with these observations in mind, among others, that various aspects of the present disclosure were conceived and developed.

### BRIEF DESCRIPTION OF THE DRAWINGS

FIG. 1 is a perspective view of an embodiment of a wafer handling apparatus;
FIG. 2 is a cross-sectional view of an existing sputtering apparatus engaged with the wafer handling apparatus of FIG. 1 showing how the wafer handling apparatus affixes to a sputtering chamber;
FIGS. **3A** and **3B** are respective frontal views of the wafer handling apparatus of FIG. **1****,** respectively, showing the wafer handling apparatus in a "wafer loading" position (FIG. **3A**) and a "wafer processing" position (FIG. **3B**);
FIGS. **4A** and **4B** are respective side views of a pin assembly of the wafer handling apparatus of FIG. **1****,** respectively showing the pin assembly in a "wafer processing" (FIG. **4A**) and "wafer loading" position (FIG. **4B**);
FIG. **5** is an enlarged view of each of the pin assemblies for the wafer handling apparatus of FIG. **1****;**
FIGS. **6A** and **6B** are respective views of the pin assemblies of the wafer handling apparatus of FIG. **1** in a "wafer loading" position (FIG. **6A**) and a "wafer processing" position (FIG. **6B**) without the wafer present and FIGS. **6C** and **6D** are respective views of the pin assemblies of the water handling apparatus of FIG. **1** in a "wafer loading" position (FIG. **6C**) and a "wafer processing" position (FIG. **6D**) with the wafer present;
FIG. **7** is a perspective view of a second embodiment of the wafer handling apparatus;
FIG. **8** is a partially exploded front view of the wafer handling apparatus of FIG. **7****;**
FIG. **9** is a partially exploded view of a heated wafer chuck of the wafer handling apparatus of FIG. **7****;**
FIG. **10** is a side view of a gas assembly of the wafer handling apparatus of FIG. **7****;**
FIG. **11** is a front view of the gas assembly of FIG. **10****;**
FIG. **12** is a perspective view of the wafer handling apparatus of FIG. **7** with a vertical rod and the gas assembly removed;
FIG. **13** is an enlarged view taken along circle **13** of an exploded feedthrough of the wafer handling apparatus of FIG. **12****;**
FIG. **14A** is a partially exploded side view of the wafer chuck of the wafer handling apparatus of FIG. **7** and a baseplate of a magnetron assembly; and
FIG. **14B** is an assembled side view of the wafer chuck of the wafer handling apparatus of FIG. **7** and the baseplate of the magnetron assembly.

Corresponding reference characters indicate corresponding elements among the view of the drawings. The headings used in the figures do not limit the scope of the claims.

### DETAILED DESCRIPTION

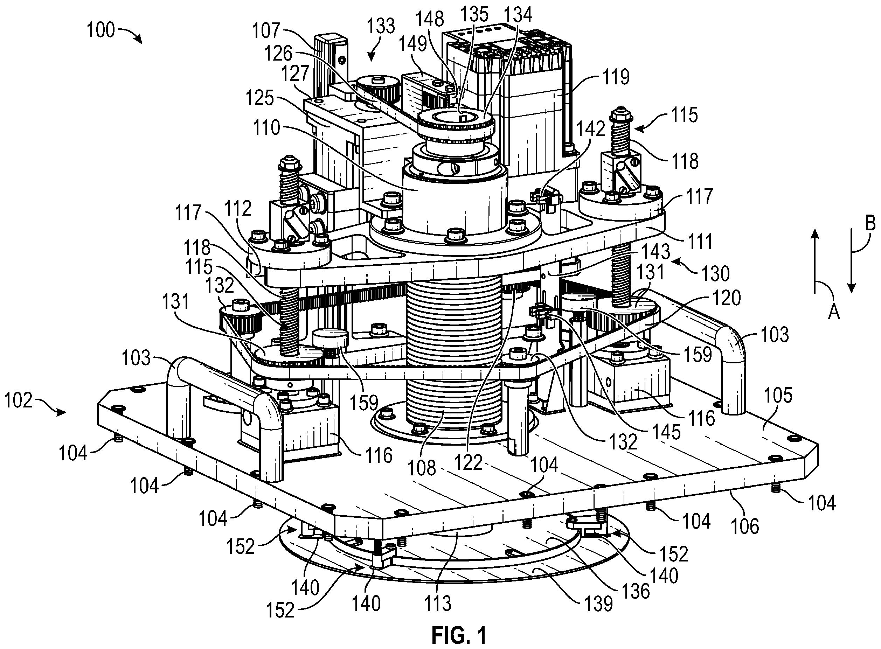

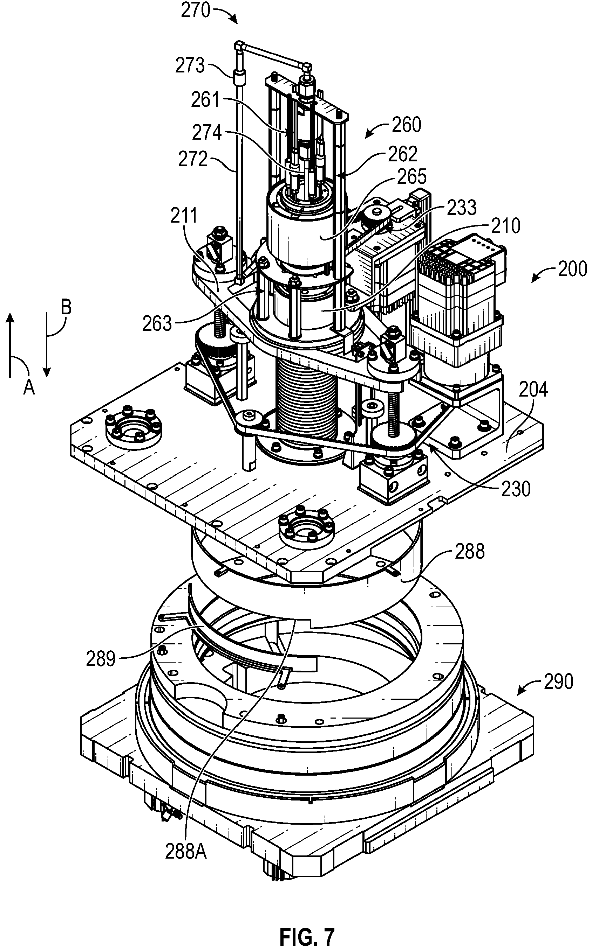

Various embodiments of a wafer handling apparatus are disclosed herein. In some embodiments, the wafer handling apparatus includes a wafer chuck associated with a vertical rod in which the vertical rod is operatively connected to two motors having respective pulley arrangements that actuate the vertical rod and the wafer chuck together in vertical and rotational movement. The wafer chuck is configured to engage a wafer to the underside of the wafer chuck for processing of the wafer within a wafer processing chamber. In some embodiments, a main plate of the wafer handling apparatus may be positioned above a wafer processing chamber such that particles ejected from a sputtering target contact the wafer engaged with the wafer chuck while the wafer chuck and wafer are in rotational or vertical motion, thereby allowing for even deposition of the particles along the wafer. In one aspect, the wafer handling apparatus may be retrofitted onto a conventional sputtering apparatus for processing a wafer engaged to the wafer chuck. Referring to the drawings, embodiments of the wafer handling apparatus are illustrated and generally indicated as **100** in FIGS. **1-6** and 200 in FIGS. **7-14****.**

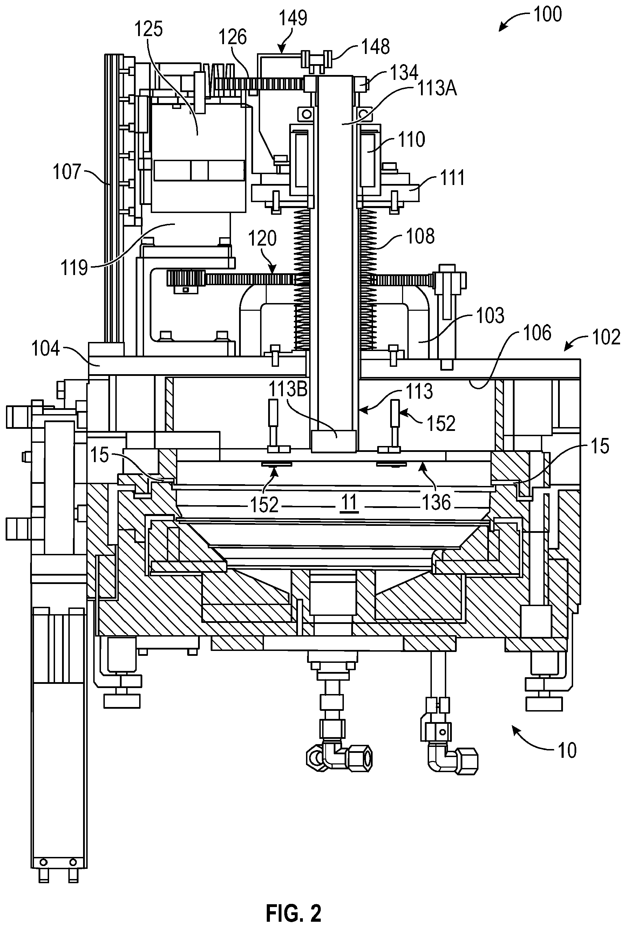

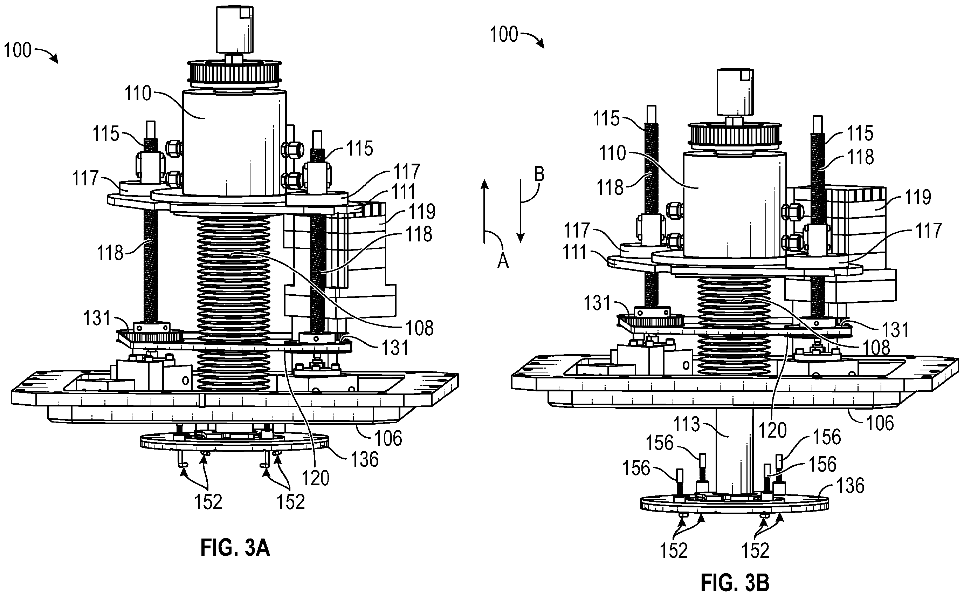

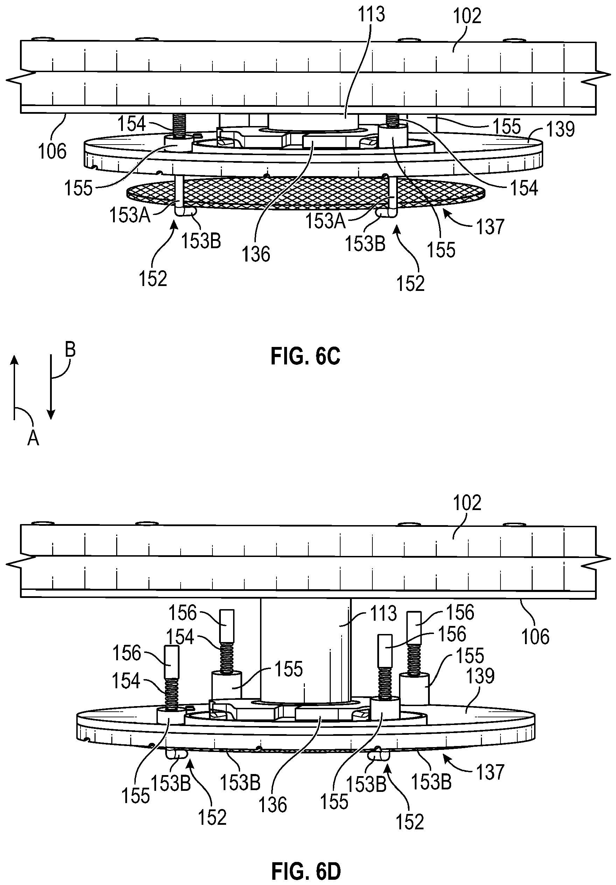

Referring to FIGS. **1-3****,** in some embodiments the wafer handling apparatus **100** is operable to engage, rotate, and lift a wafer **137** (FIGS. **6C** and **6D**) over a sputtering apparatus **10** (FIG. **2**). The wafer handling apparatus **100** includes a wafer chuck **136** located underneath a main plate **102** and in operative association with a vertical rod **113** defining a first end **113A** (FIG. **2**) and a second end **113B** (FIG. **2**), the wafer chuck **136** being defined at the second end **113B** of the vertical rod **113** and operable to receive the wafer **137** for processing. The wafer chuck **136** is lifted and/or lowered by a lifting assembly **130** associated with the vertical rod **113** to lift and/or lower the wafer **137** into a "wafer loading" position or a "wafer processing" position. The wafer chuck **136** is also rotated in a clockwise or counterclockwise direction by a rotational assembly **133** associated with the vertical rod **113** to rotate the wafer **137** in a clockwise or counterclockwise direction such that the wafer **137** is evenly coated with material during the sputtering process. In one method, to receive or offload the wafer **137,** the wafer chuck **136** is lifted in an axial direction **A** by the lifting assembly **130** into the "wafer loading" position, shown in FIG. **3A****.** To process the wafer **137,** the wafer chuck **136** is lowered into a wafer processing chamber **11** (FIG. **2**) in an opposite axial direction **B** by the lifting assembly **130** into a "wafer processing" position, shown in FIG. **3B****.** The wafer handling apparatus **100** further includes a plurality of pin assemblies **152** disposed around the wafer chuck **136** which are operable to open when the wafer chuck **136** is in the "wafer loading" position such that the wafer **137** can be inserted between the plurality of pin assemblies **152** and the wafer chuck **136,** as shown in FIG. **6C****.** In the "wafer processing" position, the plurality of pin assemblies **152** are released such that the wafer **137** is clamped against an underside of the wafer chuck **136** for processing, as shown in FIG. **6D****.** Once the wafer **137** has been processed, the wafer chuck **136** is once again lifted in an axial direction **A** into the "wafer loading" position such that the plurality of pin assemblies **152** release the wafer **137** from engagement with the wafer chuck **136** and remain open in the "wafer loading" position to receive another wafer **137.**

Referring to FIGS. **1** and **2****,** in some embodiments, the wafer handling apparatus **100** includes the main plate **102** that provides a structure for assembling the components of the wafer handling apparatus **100.** In some embodiments the main plate **102** defines a planar surface with a pair of handles **103** extending from a top face **105** of the main plate **102** for manually transporting the wafer handling apparatus **100.** Prior to operation, in some embodiments as shown in FIG. **2****,** the main plate **102** of the wafer handling apparatus **100** is engaged along a lip **15** of a sputtering apparatus **10** and in direct communication with a wafer processing chamber **11** to rest on top of the lip **15** of a sputtering apparatus **10.** The main plate **102** is secured to the lip **15** of the sputtering apparatus **10** via a plurality of securing members **104.** In one arrangement, the plurality of securing members **104** are placed equidistant from each other along the edge of the main plate **102,** thereby affixing the main plate **102** of the wafer handling apparatus **100** to the lip **15** of the sputtering apparatus **10.** An existing sputtering apparatus **10** may have its original lid (not shown) removed and be retrofitted with the wafer handling apparatus **100** in place of the original lid. In other embodiments, a sputtering apparatus **10** may be manufactured to be integral with the wafer handling apparatus **100.**

Referring to FIGS. **3A** and **3B****,** the wafer handling apparatus **100** lifts the wafer chuck **136** in the axial directions **A** and/or **B** by a lifting assembly **130.** As shown, the wafer chuck **136** and vertical rod **113** are operatively associated with a feedthrough plate **111** positioned above the main plate **102,** which can be lifted or lowered in the axial direction **A** or **B** by a pair of elongated screws **115** defined by the lifting assembly **130** as the pair of elongated screws **115** rotate in a clockwise or counterclockwise direction. The pair of elongated screws **115** are rotated by the lifting assembly **130,** which is in turn rotated by a lifting motor **119.** Further, each elongated screw **115** defines an external thread **118** for engagement with the feedthrough plate **111** by way of a pair of respective screw nuts **117,** each screw nut **117** engaging with a respective external thread **118** of the elongated screw **115.** As shown, the "wafer loading" position is shown in FIG. **3A****,** and the feedthrough plate **111** is at maximum height relative to the main plate **102.** The "wafer processing" position is shown in FIG. **3B****,** and the feedthrough plate **111** is at a lower height than the "wafer loading" position relative to the main plate **102.**

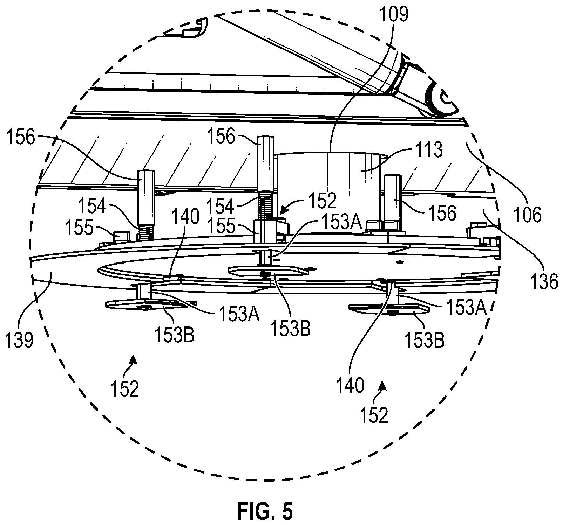

In some embodiments, the main plate **102** defines a main plate aperture **109** (FIG. **5**) with a diameter greater than or equal to a diameter of the vertical rod **113** such that the vertical rod **113** can freely move in and out of the main plate aperture **109.** As shown in FIG. **1****,** each elongated screw **115** is mounted to the top face **105** of the main plate **102** via a pair of respective screw mounts **116** located equidistant from the main plate aperture **109.** The screw mounts **116** are affixed to the top face **105** of the main plate **102,** while the elongated screws **115** are free to rotate in a clockwise or counterclockwise direction independent of the screw mounts **116.** In some embodiments, a respective lift pulley **131** of the lifting assembly **130** is secured to each elongated screw **115** of the pair of elongated screws **115** such that when each lift pulley **131** is driven in a clockwise or counterclockwise direction, each respective elongated screw **115** is also driven in a clockwise or counterclockwise direction. As shown, a lift rail **107** (FIG. **1**) may also be engaged the main plate **102** to provide support for other components of the wafer handling apparatus **100.**

As shown in FIG. **1****,** in some embodiments the main plate **104** and lifting assembly **130** includes the lifting motor **119,** which drives a lifting motor belt **120** engaged between the lifting motor **119** and the pair of lift pulleys **131.** In some embodiments, a plurality of guide pulleys **132** are affixed to the top face **105** of the main plate **102** for retaining and guiding the lifting motor belt **120.** In operation, the lifting motor **119** drives the lifting motor belt **120,** which in turn drives the lift pulleys **131** affixed to each elongated screw **115,** thereby rotating each of the elongated screws **115.** The lifting motor **119** may include one or more lifting motor control ports (not shown) in which power, and in some embodiments, communication including controls and feedback with a computing system (not shown), may be applied.

As discussed above and as shown in FIG. **1****,** the feedthrough plate **111** is defined above the main plate **102** and can be lifted or lowered relative to the main plate **102** by the operation of the lift pulleys **131** and the elongated screws **115.** The feedthrough plate **111** includes a pair of slots **112** with one slot **112** of the pair of slots **112** defined on each opposite side of the feedthrough plate **111** which are large enough for one of the respective elongated screw **115** to be inserted through. As discussed above, the feedthrough plate **111** is engaged with the external thread **118** of each elongated screw **115** via the pair of screw nuts **117.** In particular, each screw nut **117** of the pair of screw nuts **117** is affixed to the feedthrough plate **111** and engaged with the external thread **118** of the elongated screw **115** such that as the pair of elongated screws **115** rotate, the feedthrough plate **111** follows the external thread **118** by the pair of screw nuts **117.** As shown in FIG. **3A****,** as the pair of elongated screws **115** rotate in first clockwise or counterclockwise direction, the feedthrough plate **111** is lifted in an axial direction **A** relative to the main plate **102.** Conversely, as shown in FIG. **3B****,** as the pair of elongated screws **115** rotate in an opposite second clockwise or counterclockwise direction, the feedthrough plate **111** is lowered in an axial direction **B** relative to the main plate **102.**

In some embodiments and as discussed above, the vertical rod **113** is operatively coupled to the feedthrough plate **111.** As the feedthrough plate **111** is lifted or lowered in either axial direction **A** or **B** by the pair of elongated ball screws **115** in operative association with the lift motor pulley **122** and the lift pulley arrangement **130,** the vertical rod **113** is also lifted or lowered in either respective axial direction **A** or **B** relative to the main plate **102,** as shown in FIGS. **3A** and **3B****.** In some embodiments, a bellows **108** is included between an underside of the feedthrough plate **111** and the top face **105** of the main plate **102,** thereby shielding the vertical rod **113.** One or more stoppers **159** may be affixed to the top face **105** of the main plate **102** to prevent the feedthrough plate **111** from being lowered too far in an axial direction **B.**

Referring to FIG. **1****,** the wafer handling apparatus **100** rotates the wafer chuck **136** by the rotational assembly **133.** As shown, the wafer chuck **136** and vertical rod **113** are operatively associated with the feedthrough plate **111** positioned above the main plate **102.** The feedthrough plate **111** comprises a feedthrough **110** which receives the first end **113A** of the vertical rod **113,** the feedthrough **110** allows the vertical rod **113** to rotate freely within the feedthrough **110** while securing the first end **113A** of the vertical rod **113** to the feedthrough plate **111.** A rotational pulley **134** is rotated by a rotational motor **125** and operatively engaged with the first end **113A** of the vertical rod **113** for clockwise or counterclockwise rotation of the vertical rod **113,** which in turn rotates the wafer chuck **136** in a clockwise or counterclockwise direction.

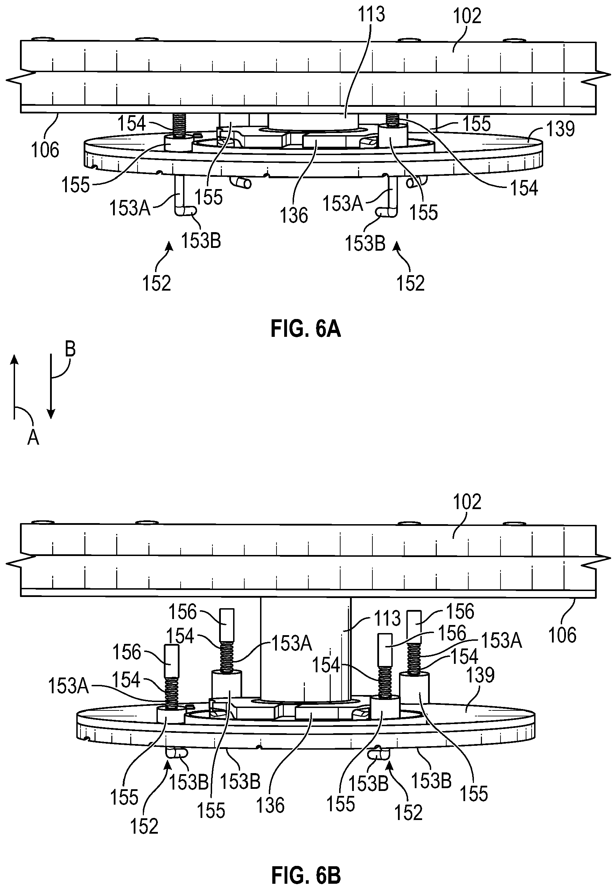

As shown in FIG. **1****,** the rotational motor **125** which rotates the rotational pulley **134** is affixed to the feedthrough plate **111** via a rotational motor mount **127.** The rotational motor **125** drives a rotational motor belt **126** engaged between the rotational motor **125** and the rotational pulley **134.** In some embodiments, the rotational pulley **134** comprises an aperture **135** through its center such that a photoelectric sensor **148** can "look" down through the rotational pulley **134,** vertical rod **113** and at the wafer **137** (FIGS. **6A** and **6B**) when engaged with the wafer chuck **136** to determine the presence of the wafer **137.** The rotational motor **125** may have one or more rotational motor control ports (not shown) in which power, and in some embodiments, communication including controls and feedback with a computing system (not shown), may be applied.

As further shown in FIGS. **6A-6D****,** the second end **113B** of the vertical rod **113** is operatively engaged with the wafer chuck **136.** In some embodiments, an annular wafer shield **139** is defined around an outer edge of the wafer chuck **136.** The wafer shield **139** defines a plurality of apertures **140** spaced equidistant from a center of the wafer chuck **136** such that the plurality of pin assemblies **152** are mounted along the edge of the wafer chuck **136** and each pin assembly **152** disposed through a respective one of the plurality of apertures **140** of the wafer shield **139.** As shown in FIGS. **6C** and **6D****,** the wafer chuck **136** and pin assemblies **152** are operable to engage the wafer **137** and clamp the wafer **137** to the underside of the wafer chuck **136** such that when the vertical rod **113** is moved in either axial direction **A** or **B** or rotated in a clockwise or counterclockwise direction, the wafer chuck **136** and wafer **137** are concurrently moved as well.

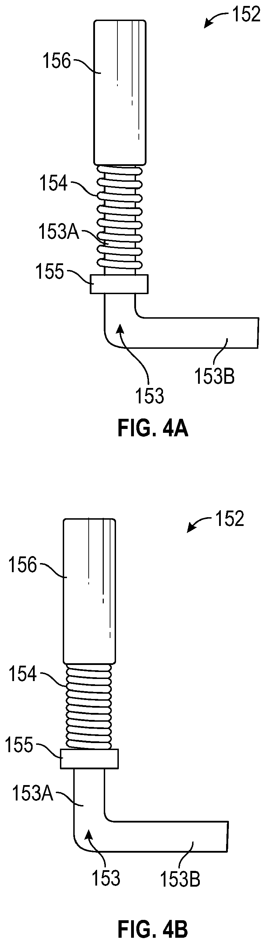

Referring to FIGS. **4A, 4B****,** **5****,** and **6A****-6D,** in some embodiments, the plurality of pin assemblies **152** include an "L"- shaped pin **153** including a vertical section **153A** and a lateral section **153B.** As shown specifically in FIGS. **6A** and **6C****,** each vertical section **153A** includes a pin cap **156** which, while in a "wafer loading" position, contacts an underside **106** of the main plate. Each pin assembly **152** is disposed through a respective securing piece **155,** each securing piece **155** being engaged to a circumferential edge of the wafer chuck **136.** In some embodiments, each vertical section **153A** of the pin **153** is sheathed by a spring **154** located between the pin cap **156** and the securing piece **155,** allowing each pin assembly **152** to clutch the wafer **137** against the underside of the wafer chuck while in the "wafer processing" position, as shown in FIGS. **6B** and **6D****.** As shown in FIGS. **6A** and **6C****,** when the vertical rod **113** and the wafer chuck **136** are lifted to the "wafer loading" position, each pin cap **156** contacts the underside **106** of the main plate **102** and compresses each spring **154** such that each respective pin **153** is lowered into the "wafer loading" position which maximizes a transfer gap between the lateral section **156** of each pin **152** and the underside of the wafer chuck **136** such that the wafer **137** may be inserted or removed. As shown in FIGS. **6B** and **6D****,** the vertical rod **113** and wafer chuck **136** are lowered out of the loading position, the pin cap **156** no longer contacts the lower face **106** of the main plate **102** and each spring **154** will be allowed to assume a decompressed state and lift each pin **153** into a "wafer processing" position. In this "wafer processing" position, the wafer **137** is clamped in place to the underside of the wafer chuck **136** for processing by the lateral section **153B** of each pin assembly **152.**

Referring back to FIG. **1****,** in some embodiments, the wafer handling apparatus **100** includes one or more sensors for determining a presence of the wafer **137** (FIGS. **6A** and **6B**) engaged with the wafer chuck **136** and in some embodiments, for measurement of a height to which the wafer chuck **136** is lifted or lowered. In some embodiments, the photoelectric sensor **148** is mounted using a photoelectric sensor mounting bracket **149** positioned above the rotational pulley **134.** In one embodiment, a line-of-sight of the photoelectric sensor **148** is aimed downward through the aperture **135** in the rotational pulley **134,** the vertical rod **113,** and/or an aperture **138** through the center of the wafer chuck **136** to determine if the wafer **137** is presently engaged with the wafer chuck **136.** In the present disclosure, a sensor mounting bracket **143** is affixed to the top face **105** of the main plate **102** and disposed through a feedthrough plate aperture not shown). In some embodiments, an upper sensor **142** and a lower sensor **145** are mounted along the sensor mounting bracket **143,** the upper sensor **142** being mounted at the top portion of the sensor mounting bracket **143** above the feedthrough plate **111** and the lower sensor **145** being mounted on the sensor mounting bracket **143** at variable height below the feedthrough plate **111.** In one aspect, the upper sensor **142** and lower sensor **145** may be used to monitor the height of the feedthrough plate **111** to ensure that the feedthrough plate **111** does not exceed its maximum or minimum height and to otherwise ensure proper operation of the wafer handling apparatus **100.**

In some embodiments the wafer handling apparatus **100** is operable to engage, rotate, and lift the wafer **137** within the sputtering apparatus **10** when the wafer handling apparatus **100** is operatively engaged to the sputtering apparatus **10.** In some embodiments, the existing sputtering apparatus **10** may be retrofitted with the wafer handling apparatus **100** by removing the lid **17** (FIG. **2A**) of the sputtering apparatus **10** and securing the wafer handling apparatus **100** to the lip **15** (FIG. **2B**) of the sputtering apparatus **10** using the plurality of securing members **104.** In other embodiments, a sputtering apparatus **10** may be designed to wholly integrate the wafer handling apparatus **100.**

In one method of processing the wafer **137** using the wafer handling apparatus **100,** the vertical rod **113** lifts the wafer chuck **136** to a maximum height relative to the main plate **102** into a "wafer loading" position by the lifting assembly **130** in conjunction with the pair of elongated ball screws **115.** While in the "wafer loading" position, the plurality of pin assemblies **152** are operable to open and receive the wafer **137,** as shown in FIGS. **3B****,** **6A** and **6C****.** The vertical rod **113** lowers the wafer chuck **136** to a variable "wafer processing" position relative to the main plate **102** within the sputtering chamber **11** of the sputtering apparatus **10,** as shown in FIGS. **3A** and **5A.** In this position, the plurality of pin assemblies **152** physically clamps the wafer **137** against an underside of the wafer chuck **136.** The vertical rod **113** rotates the wafer chuck **136** and the wafer **137** by operation of the rotational assembly **133** such that the wafer **137** may be contacted by particles from the sputtering apparatus **10** while the wafer **137** is being rotated. Once the wafer **137** has been processed, the vertical rod **113** lifts and returns the wafer chuck **136** to the "wafer loading" position, where the plurality of pin assemblies **152** release the wafer and remain open and in position to receive another wafer **137.**

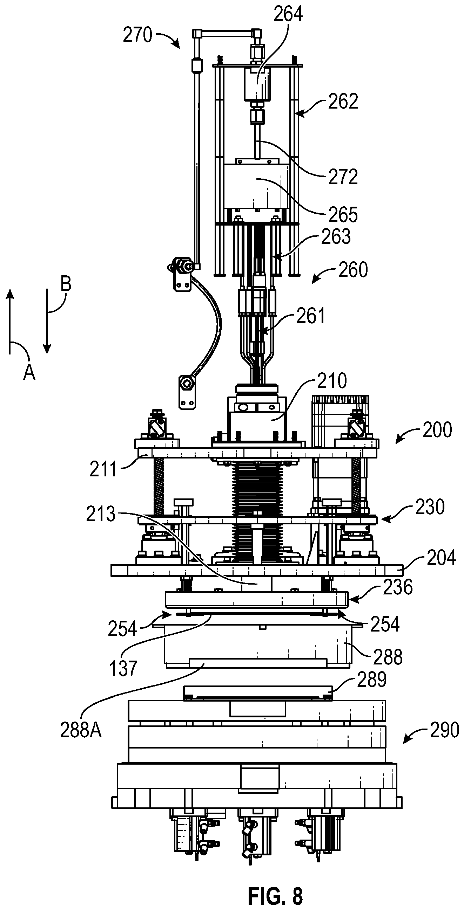

Referring to FIGS. **7** and **8****,** a second embodiment of the wafer handling apparatus **200** is shown including a wafer chuck **236,** the wafer chuck **236** being defined at a lower end of a vertical rod **213** and operable to receive a wafer **137.** As shown, the wafer handling apparatus **200** is similar to the wafer handling apparatus **100** including the vertical rod **213** in association with a feedthrough plate **211** by a feedthrough **210,** a lifting assembly **230** for lifting or lowering the feedthrough plate **211** and consequently the heated wafer chuck **236** in an axial direction **A** or **B** relative to a main plate **204,** and a rotational assembly **233** in communication with the feedthrough **210** and vertical rod **213** for rotation of the vertical rod **213** and heated wafer chuck **236.** As discussed above, the lifting assembly **230,** like the lifting assembly **130,** is operable for lifting the wafer chuck **236** into a "wafer loading" position such that a plurality of pin assemblies **252** disposed around the wafer chuck **236** open and receive a wafer **137.** The lifting assembly **230** is also operable for lowering the wafer chuck **236** into the "wafer processing" position such that the plurality of pin assemblies **252** secure the wafer **137** against an underside of the wafer chuck **236.**

The wafer handling apparatus **200** further includes a thermoelectric assembly **260** and a gas assembly **270** in association with the feedthrough **210,** vertical rod **213** and heated wafer chuck **236** for introducing power and gas to the heated wafer chuck **236.** As shown, the wafer handling apparatus **200** is configured to be positioned above a baseplate **290** of a magnetron assembly for physical vapor deposition of material (not shown) onto the wafer **137.** As shown, a shield **288** is included between the baseplate **290** of the magnetron assembly and the main plate **204** of the wafer handling apparatus **200.**

As shown directly in FIGS. **7** and **8****,** the thermoelectric assembly **260** and the gas assembly **270** mounted to the feedthrough plate **211** by an upper frame **262** and a lower frame **263** for delivery of gas and power to the wafer chuck **236.** Power delivery to the wafer chuck **236** is achieved through one or more power conduits **261** in electrical communication with the wafer chuck **236.** In some embodiments the wafer chuck **236** may include one or more heating elements (not shown). The gas assembly **270** is shown in communication with the wafer chuck **236.** The gas exits the wafer chuck **236** through a small aperture (not shown) defined on an underside of the wafer chuck **236** to provide uniformity of heat distribution to the wafer **137.** As the rotational assembly **233** rotates the vertical rod **213** similar to the rotational assembly **133** of the wafer handling apparatus **100,** a rotary union **264** and a slip ring **265** are respectively defined by the gas assembly **270** and the thermoelectric assembly **260** for preserving fluid flow communication of the gas assembly **270** with the wafer chuck **236** and preserving electrical communication of the one or more power conduits **261** with the wafer chuck **236.**

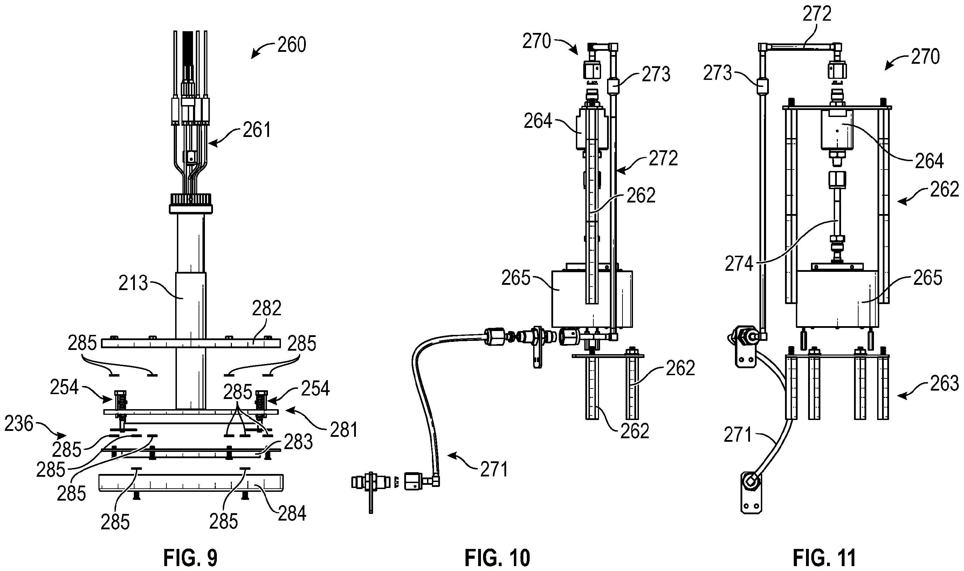

FIG. **9** illustrates the wafer chuck **236** defined at a lower end of the vertical rod **213.** As shown, the wafer chuck **236** includes a wafer chuck component **281,** similar to the wafer chuck **136** of the wafer handling assembly **100,** which includes a plurality of pin assemblies **254** which are operable for receiving and securing the electronic wafer **137** against an underside of the wafer chuck component **281.** In some embodiments, the wafer chuck **236** is in electrical communication with the thermoelectric assembly **260** for applying heat to the wafer **137,** and may include one or more heating elements (not shown) for generating heat. As shown, the wafer chuck **236** further includes an upper shield **282** defined above the wafer chuck component **281,** a lower shield **283** defined below the wafer chuck component **281,** and an outer covering **284** which encapsulates the wafer chuck component **281,** all which serve the purpose of conserving heat and directing heat towards the wafer chuck component **281** and consequently, the electronic wafer **137.** The wafer chuck **236** further includes a plurality of spacers **285** for electrical and thermal insulation. In some embodiments each of the plurality of spacers **285** is of a thermally and electrically insulating material such as ceram ic.

Referring to FIGS. **7****,** **9** and **11****,** the wafer chuck **237** is in electrical communication with the thermoelectric assembly **260,** and in particular with the one or more power conduits **261** which may include one or more thermocouples and extend from the upper frame **262.** As shown, the thermoelectric assembly **260** includes an electrical slip ring **265** for enabling electrical communication between the one or more power conduits **261** and the wafer chuck **236** while the vertical rod **213** and wafer chuck **236** are rotated independently of the upper frame **262.** In some embodiments, the electrical slip ring **265** is supported above the feedthrough **210** by the lower frame **263.**

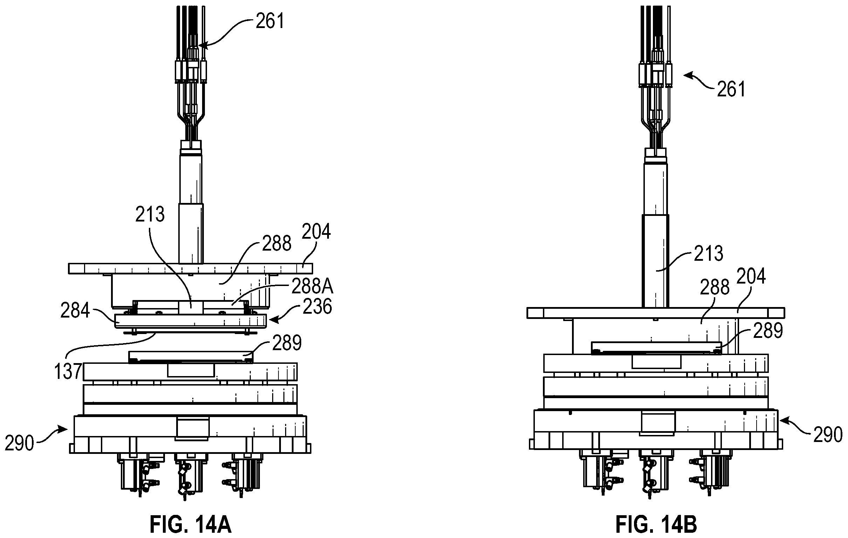

Referring directly to FIGS. **10** and **11****,** the gas assembly **270** comprises a gas inlet **271** in fluid flow communication with an external gas source (not shown) for introduction of a non-reactive gas, usually argon, for physical vapor deposition onto the wafer **137** (FIG. **14A****).** The gas inlet **271** transfers gas from the external source (not shown) to a gas line **272.** In some embodiments, a cryogenic break **273** is included along the gas line **272** to provide a safety measure if the gas line **272** is broken or otherwise damaged. As shown, the gas line **272** terminates at a rotary union **264** for maintaining fluid flow communication to the heated chuck **236** while the heated chuck **236** and vertical rod **213** are rotated by the rotational assembly **233.** The rotary union **264** and gas line **272** are supported above the feedthrough plate **211** by the upper frame **262.** A secondary gas line **274** connects the rotary union **264** to the wafer chuck **236** and in some embodiments extends downward through the vertical rod **213** to terminate in the small aperture (not shown) defined on the underside (not shown) of the wafer chuck **236.** The introduction of gas at the wafer chuck **236** while heat is concurrently applied to the wafer **137** allows for improved heat distribution uniformity across the wafer **137.**

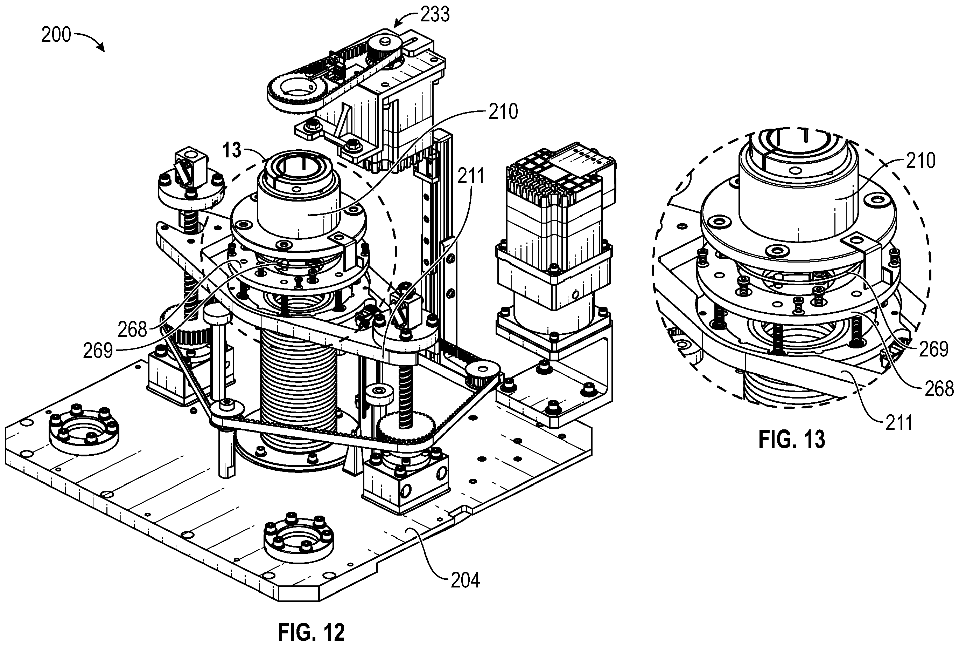

Referring to FIGS. **12** and **13****,** the feedthrough **210** is separated from the feedthrough plate **211** by an annular isolator **268.** In some embodiments, the annular isolator **268** is an electrically insulating material such as Teflon. As shown, one or more O-rings **269** are included between the annular isolator **268** and the feedthrough **210** for ensuring an airtight connection between the gas assembly **270** (FIG. **11****)** and the wafer chuck **236.**

Referring to FIGS. **14A** and **14B****,** the wafer chuck **236** is disposed above the baseplate **290** of a magnetron assembly defining a wafer processing chamber. As shown, the shield **288** is secured underneath the main plate **204** of the wafer handling apparatus **200** and encapsulates the wafer chuck **236** such that an environment within the wafer processing chamber is controlled in terms of gas flow rate and pressure, as specifically shown in the assembled view of FIG. **14B****.** As shown, the shield **288** includes a slot **288A** for insertion of a wafer **137** when in the "wafer loading" position. While in the "wafer processing" position, when the wafer **137** is being processed within the wafer processing chamber, the slot **288A** is sealed by a slot guard **289** which is operable to move in and out of position to allow the wafer **137** to be inserted and removed when the wafer chuck **236** is in the "wafer loading" position and to seal the slot **288A** when the wafer chuck **236** is in the "wafer processing" position.

It should be understood from the foregoing that, while particular embodiments have been illustrated and described, various modifications can be made thereto without departing from the scope of the invention as defined in the claims appended hereto

## Claims

1. A wafer handling apparatus (100), comprising:
a feedthrough plate (111) in operative association with a first end (113A) of a vertical rod (113), wherein the feedthrough plate (111) is operable to be lifted in an axial direction A to a wafer loading position and wherein the feedthrough plate (111) is operable to be lowered in an opposite axial direction B to a wafer processing position;
a main plate (104) defining a lower face (106) and a main plate aperture (109), wherein the feedthrough plate (111) is positioned above the main plate (104) such that the vertical rod (113) extends through the main plate aperture (109);
a wafer chuck (136) coupled with a second end (113B) of the vertical rod (113) and positioned below the main plate (104); and
a plurality of pin assemblies (152) defined annularly around the wafer chuck (136), wherein each pin assembly (152) of the plurality of pin assemblies (152) comprises a lateral leg (153B);
wherein when the feedthrough plate (111) is lifted to the wafer loading position, a transfer gap between the wafer chuck (136) and each lateral leg (153B) of each pin assembly (152) of the plurality of pin assemblies (152) is maximized such that an electronic wafer (137) may be inserted between the wafer chuck (136) and each lateral leg (153B) of each pin assembly (152) of the plurality of pin assemblies (152); and
wherein when the feedthrough plate (111) is lowered to the wafer processing position, a transfer gap between the wafer chuck (136) and each lateral leg (153B) of each pin assembly (152) of the plurality of pin assemblies (152) is minimized such that the electronic wafer (137) is secured to the wafer chuck (136) by each lateral leg (153B) of each pin assembly (152) of the plurality of pin assemblies (152).

2. The wafer handling apparatus of claim 1, further comprising:
a lifting assembly (130) in operative association with the feedthrough plate (111), the lifting assembly (130) comprising:
a plurality of elongated screws (115), each elongated screw (115) of the plurality of elongated screws (115) defining an external thread (118) and wherein each elongated screw (115) of the plurality of elongated screws (115) is operable for rotation about a vertical axis;
wherein each elongated screw (115) of the plurality of elongated screws (115) is coupled with a respective lift pulley (131) of a plurality of lift pulleys (131) such that when each lift pulley (131) is driven in a clockwise or counterclockwise direction, each elongated screw (115) of the plurality of elongated screws (115) is rotated in a clockwise or counterclockwise direction; and
a lifting motor (119) in operative association with each of the plurality of lift pulleys (115), wherein the lifting motor (119) drives each lift pulley (115) of the plurality of lift pulleys (115) in a clockwise or counterclockwise direction;
wherein the external thread (118) of each elongated screw (115) of the plurality of elongated screws (115) is operatively engaged with the feedthrough plate (111) by a respective screw nut (117) of the plurality of screw nuts (117) such that as the plurality of elongated screws (115) are rotated in a clockwise or counterclockwise direction, the feedthrough plate (111) is lifted in the axial direction A or lowered in the axial direction B.

3. The wafer handling apparatus of claim 1, further comprising:
a rotational assembly (133) in operative association with the vertical rod (113), the rotational assembly (133) comprising:
a rotational pulley (134) coupled with the first end (113A) of the vertical rod (113), wherein when the rotational pulley (134) is driven in a clockwise or counterclockwise direction, the vertical rod (113) is rotated in a clockwise or counterclockwise direction; and
a rotational motor (125) in operative association with the rotational pulley (134), wherein the rotational motor (125) drives the rotational pulley (134) in a clockwise or counterclockwise direction.

4. The wafer handling apparatus of claim 1, wherein the pin assembly (152) further comprises:
a pin (153) defining an L-shaped body comprising a vertical leg (153A) and the lateral leg (153B), the vertical leg (153A) comprising:
an upper portion and the lower portion, wherein the lateral leg extends from the lower portion of the vertical leg.

5. The wafer handling apparatus of claim 4, further comprising:
a pin cap (156) defined at the upper portion of the vertical leg (153A); and
a spring (154) sheathing the vertical leg (153A) such that the spring (154) is positioned between the pin cap (156) and the wafer chuck (136);
wherein the spring (154) compresses between the pin cap (156) and the wafer chuck (136) such that the transfer gap between the wafer chuck (136) and each lateral leg (153B) of each pin assembly (152) of the plurality of pin assemblies (152) is maximized; and
wherein the spring (154) decompresses and pushes the pin cap (156) away from the wafer chuck (136) such that the transfer gap between the wafer chuck (136) and each lateral leg (153B) of each pin assembly (152) of the plurality of pin assemblies (152) is minimized.

6. The wafer handling apparatus of claim 5, wherein when the wafer chuck (136) and the vertical rod (113) are lifted to the wafer loading position, the pin cap (156) contacts a lower face (106) of the main plate (104) and compresses the spring (154) such that the transfer gap is maximized.

7. The wafer handling apparatus of claim 6, wherein when the wafer chuck (136) and the vertical rod (113) are lowered to the wafer processing position, the pin cap (156) separates from the lower face (106) of the main plate (104) and decompresses the spring (154) such that the transfer gap is minimized.

8. The wafer handling apparatus of claim 1, wherein the wafer chuck (136) is operable to engage the wafer (137) and dispose the wafer (137) within a sputtering chamber (10) engaged to the wafer handling apparatus (100).

9. The wafer handling apparatus of claim 1, further comprising:
a photoelectric sensor (148) operable for detecting the presence of the wafer (137); and
one or more sensors (142, 145) operable for detecting a vertical position of the feedthrough plate (111) relative to the main plate (104);
wherein the photoelectric sensor (148) and one or more sensors (142, 145) are in operative communication with a computing system for determining a vertical distance between the feedthrough plate (111) and the main plate (104).

10. The wafer handling apparatus of claim 1, further comprising a feedthrough (110), wherein the feedthrough (110) is operatively engaged to the first end (113A) of the vertical rod (113) and affixed to the feedthrough plate (111), and wherein the feedthrough (110) enables rotation of the vertical rod (113) independent of the feedthrough plate (111).

11. A method for lifting and rotating a wafer using a wafer handling apparatus according to any of the claims 1 to 10,
comprising:
rotating each of a plurality of elongated screws (115) having external threads (118) in a clockwise or counterclockwise direction, wherein the plurality of elongated screws (115) are in operative engagement with a feedthrough plate (111) such that as each of the plurality of elongated screws (115) rotate in a clockwise direction or a counterclockwise direction the feedthrough plate (111) is lifted in an axial direction A or lowered in an axial direction B; and
rotating a vertical rod (113) coupled to a wafer chuck (136) in a clockwise direction or a counterclockwise direction, wherein the vertical rod (113) is in operative engagement with the feedthrough plate (111) such that when the feedthrough plate (111) is lifted or lowered in opposing axial directions A or B, the vertical rod (113) and wafer chuck (136) are similarly lifted or lowered in opposing axial directions A or B.

12. The method of claim 11, wherein each of the plurality of elongated screws (115) is rotated by a lifting assembly (130) comprising a lift pulley (131) driven by a lifting motor (119).

13. The method of claim 11, wherein the feedthrough plate (111) is operatively engaged to the external threads (118) of each of the plurality of elongated screws (115) using a respective screw nut (117), wherein each of the plurality of screw nuts (117) comprise an internal threading in operative engagement with the external threads (118) of the respective elongated screw (115) and each of the plurality of screw nuts (117) is affixed to the feedthrough plate (111).

14. The method of claim 11, wherein the vertical rod (113) is rotated by a rotational assembly (133) comprising a rotational pulley (134) driven by a rotational motor (125).

15. A method for receiving and securing a wafer using a wafer handling apparatus according to any of the claims 1 to 10,
comprising:
opening a pin assembly (152) by lifting a wafer chuck (136) in an axial direction such that a pin cap (136) of the pin assembly (152) contacts a lower face (106) of a main plate (104) and compresses a spring (156) such that a pin (153) of the pin assembly (152) is lowered and a transfer gap between a lateral leg (153B) of the pin (153) and the wafer chuck (136) is maximized; and
closing the pin assembly (152) by lowering the wafer chuck (136) in an opposite axial direction such that the pin cap (156) no longer contacts the lower face (106) of the main plate (104) and the spring (156) assumes a decompressed position such that the pin (153) is lifted and a transfer gap defined between the lateral leg (153B) of the pin (152) and the wafer chuck (136) is minimized;
wherein a wafer (137) may be inserted or removed when the pin assembly (152) is open and the wafer (137) may be secured to the wafer chuck (136) when the pin assembly (152) is closed.

## Patentansprüche

1. Wafer-Handhabungsvorrichtung (100), umfassend:
eine Durchführungsplatte (111) in Wirkverbindung mit einem ersten Ende (113A) einer vertikalen Stange (113), wobei die Durchführungsplatte (111) betriebsfähig ist, um in einer axialen Richtung A in eine Wafer-Ladeposition gehoben zu werden, und wobei die Durchführungsplatte (111) betriebsfähig ist, um in einer entgegengesetzten axialen Richtung B in eine Wafer-Verarbeitungsposition gesenkt zu werden;
eine Hauptplatte (104), die eine Unterseite (106) und eine Hauptplattenöffnung (109) definiert, wobei die Durchführungsplatte (111) über der Hauptplatte (104) derart positioniert ist, dass der vertikale Stab (113) sich durch die Hauptplattenöffnung (109) erstreckt;
einen Wafer-Chuck (136), der mit einem zweiten Ende (113B) der vertikalen Stange (113) gekoppelt und unterhalb der Hauptplatte (104) positioniert ist; und
eine Vielzahl von Stiftanordnungen (152), die ringförmig um den Wafer-Chuck (136) herum definiert sind, wobei jede Stiftanordnung (152) der Vielzahl von Stiftanordnungen (152) einen seitlichen Schenkel (153B) umfasst;
wobei, wenn die Durchführungsplatte (111) in die Wafer-Ladeposition gehoben wird, ein Übertragungsspalt zwischen dem Wafer-Chuck (136) und jedem seitlichen Schenkel (153B) jeder Stiftanordnung (152) der Vielzahl von Stiftanordnungen (152) derart maximiert wird, dass ein elektronischer Wafer (137) zwischen dem Wafer-Chuck (136) und jedem seitlichen Schenkel (153B) jeder Stiftanordnung (152) der Vielzahl von Stiftanordnungen (152) eingefügt werden kann; und
wobei, wenn die Durchführungsplatte (111) in die Wafer-Verarbeitungsposition gesenkt wird, ein Übertragungsspalt zwischen dem Wafer-Chuck (136) und jedem seitlichen Schenkel (153B) jeder Stiftanordnung (152) der Vielzahl von Stiftanordnungen (152) derart minimiert wird, dass der elektronische Wafer (137) an dem Wafer-Chuck (136) durch jeden seitlichen Schenkel (153B) jeder Stiftanordnung (152) der Vielzahl von Stiftanordnungen (152) gesichert wird.

2. Wafer-Handhabungsvorrichtung nach Anspruch 1, ferner umfassend:
eine Hebeanordnung (130) in Wirkverbindung mit der Durchführungsplatte (111), die Hebeanordnung (130) umfassend:
eine Vielzahl von länglichen Schrauben (115), wobei jede längliche Schraube (115) der Vielzahl von länglichen Schrauben (115) ein Außengewinde (118) definiert und wobei jede längliche Schraube (115) der Vielzahl von länglichen Schrauben (115) für eine Drehung um eine vertikale Achse betriebsfähig ist;
wobei jede längliche Schraube (115) der Vielzahl von länglichen Schrauben (115) mit einer jeweiligen Hubscheibe (131) einer Vielzahl von Hubscheiben (131) derart gekoppelt ist, dass, wenn jede Hubscheibe (131) in einer Richtung im Uhrzeigersinn oder gegen den Uhrzeigersinn angetrieben wird, jede längliche Schraube (115) der Vielzahl von länglichen Schrauben (115) in einer Richtung im Uhrzeigersinn oder gegen den Uhrzeigersinn gedreht wird; und
einen Hubmotor (119) in Wirkverbindung mit jeder der Vielzahl von Hubscheiben (115), wobei der Hubmotor (119) jede Hubscheibe (115) der Vielzahl von Hubscheiben (115) in einer Richtung im Uhrzeigersinn oder gegen den Uhrzeigersinn antreibt;
wobei das Außengewinde (118) jeder länglichen Schraube (115) der Vielzahl von länglichen Schrauben (115) durch eine jeweilige Schraubenmutter (117) der Vielzahl von Schraubenmuttern (117) mit der Durchführungsplatte (111) derart in Wirkeingriff steht, dass, wenn die Vielzahl der länglichen Schrauben (115) in einer Richtung im Uhrzeigersinn oder gegen den Uhrzeigersinn gedreht werden, die Durchführungsplatte (111) in der axialen Richtung A gehoben oder in der axialen Richtung B gesenkt wird.

3. Wafer-Handhabungsvorrichtung nach Anspruch 1, ferner umfassend:
eine Drehanordnung (133) in Wirkverbindung mit der vertikalen Stange (113), die Drehanordnung (133) umfassend:
eine Drehscheibe (134), die mit dem ersten Ende (113A) der vertikalen Stange (113) gekoppelt ist, wobei, wenn die Drehscheibe (134) in einer Richtung im Uhrzeigersinn oder gegen den Uhrzeigersinn angetrieben wird, die vertikale Stange (113) in einer Richtung im Uhrzeigersinn oder gegen den Uhrzeigersinn gedreht wird; und
einen Drehmotor (125) in Wirkverbindung mit der Drehscheibe (134), wobei der Drehmotor (125) die Drehscheibe (134) in einer Richtung im Uhrzeigersinn oder gegen den Uhrzeigersinn antreibt.

4. Wafer-Handhabungsvorrichtung nach Anspruch 1, wobei die Stiftanordnung (152) ferner umfasst:
einen Stift (153), der einen L-förmigen Körper definiert, umfassend einen vertikalen Schenkel (153A) und einen seitlichen Schenkel (153B), der vertikale Schenkel (153A) umfassend:
einen oberen Abschnitt und den unteren Abschnitt, wobei der seitliche Schenkel sich von dem unteren Abschnitt des vertikalen Schenkels erstreckt.

5. Wafer-Handhabungsvorrichtung nach Anspruch 4, ferner umfassend:
eine Stiftkappe (156), die an dem oberen Abschnitt des vertikalen Schenkels (153A) definiert ist; und
eine Feder (154), die das vertikale Bein (153A) derart umhüllt, dass die Feder (154) zwischen der Stiftkappe (156) und dem Wafer-Chuck (136) positioniert ist;
wobei die Feder (154) zwischen der Stiftkappe (156) und dem Wafer-Chuck (136) derart zusammengedrückt wird, dass der Übertragungsspalt zwischen dem Wafer-Chuck (136) und jedem seitlichen Schenkel (153B) jeder Stiftanordnung (152) der Vielzahl von Stiftanordnungen (152) maximiert wird; und
wobei die Feder (154) sich dekomprimiert und die Stiftkappe (156) von dem Wafer-Chuck (136) derart weg drückt, dass der Übertragungsspalt zwischen dem Wafer-Chuck (136) und jedem seitlichen Schenkel (153B) jeder Stiftanordnung (152) der Vielzahl von Stiftanordnungen (152) minimiert wird.

6. Wafer-Handhabungsvorrichtung nach Anspruch 5, wobei, wenn der Wafer-Chuck (136) und die vertikale Stange (113) in die Wafer-Ladeposition gehoben werden, die Stiftkappe (156) eine Unterseite (106) der Hauptplatte (104) berührt und die Feder (154) derart zusammendrückt, dass der Übertragungsspalt maximiert wird.

7. Wafer-Handhabungsvorrichtung nach Anspruch 6, wobei, wenn der Wafer-Chuck (136) und die vertikale Stange (113) in die Wafer-Verarbeitungsposition gesenkt werden, die Stiftkappe (156) sich von der Unterseite (106) der Hauptplatte (104) löst und die Feder (154) sich derart dekomprimiert, dass der Übertragungsspalt minimiert wird.

8. Wafer-Handhabungsvorrichtung nach Anspruch 1, wobei der Wafer-Chuck (136) betriebsfähig ist, um in den Wafer (137) einzugreifen und den Wafer (137) innerhalb einer Sputterkammer (10) anzuordnen, die mit der Wafer-Handhabungsvorrichtung (100) in Eingriff steht.

9. Wafer-Handhabungsvorrichtung nach Anspruch 1, ferner umfassend:
einen fotoelektrischen Sensor (148), der zum Erkennen der Anwesenheit des Wafers (137) betriebsfähig ist; und
einen oder mehrere Sensoren (142, 145), die zum Erkennen einer vertikalen Position der Durchführungsplatte (111) relativ zu der Hauptplatte (104) betriebsfähig sind;
wobei der fotoelektrische Sensor (148) und ein oder mehrere Sensoren (142, 145) in Wirkverbindung mit einem Computersystem stehen, um einen vertikalen Abstand zwischen der Durchführungsplatte (111) und der Hauptplatte (104) zu bestimmen.

10. Wafer-Handhabungsvorrichtung nach Anspruch 1, ferner umfassend: eine Durchführung (110) umfasst, wobei die Durchführung (110) mit dem ersten Ende (113A) der vertikalen Stange (113) in Wirkeingriff steht und an der Durchführungsplatte (111) befestigt ist, und wobei die Durchführung (110) eine Drehung der vertikalen Stange (113) unabhängig von der Durchführungsplatte (111) ermöglicht.

11. Verfahren zum Heben und Drehen eines Wafers unter Verwendung einer Wafer-Handhabungsvorrichtung nach einem der Ansprüche 1 bis 10, umfassend:
Drehen jeder einer Vielzahl von länglichen Schrauben (115), die Außengewinde (118) aufweisen, in einer Richtung im oder gegen den Uhrzeigersinn, wobei die Vielzahl von länglichen Schrauben (115) in Wirkeingriff mit einer Durchführungsplatte (111) derart steht, dass, wenn jede der Vielzahl von länglichen Schrauben (115) sich in einer Richtung im Uhrzeigersinn oder gegen den Uhrzeigersinn dreht, die Durchführungsplatte (111) in einer axialen Richtung A gehoben oder in einer axialen Richtung B gesenkt wird; und
Drehen einer vertikalen Stange (113), die mit einem Wafer-Chuck (136) gekoppelt ist, in einer Richtung im Uhrzeigersinn oder gegen den Uhrzeigersinn, wobei die vertikale Stange (113) in Wirkeingriff mit der Durchführungsplatte (111) derart steht, dass, wenn die Durchführungsplatte (111) in entgegengesetzte axiale Richtungen A oder B gehoben oder gesenkt wird, die vertikale Stange (113) und der Wafer-Chuck (136) ähnlich in entgegengesetzte axiale Richtungen A oder B gehoben oder gesenkt werden.

12. Verfahren nach Anspruch 11, wobei jede der Vielzahl von länglichen Schrauben (115) durch eine Hebeanordnung (130) gedreht wird, umfassend eine durch einen Hubmotor (119) angetriebene Hubscheibe (131).

13. Verfahren nach Anspruch 11, wobei die Durchführungsplatte (111) unter Verwendung einer jeweiligen Schraubenmutter (117) mit den Außengewinden (118) jeder der Vielzahl von länglichen Schrauben (115) in Wirkeingriff steht, wobei jede der Vielzahl von Schraubenmuttern (117) ein Innengewinde umfasst, das mit den Außengewinden (118) der jeweiligen länglichen Schraube (115) in Wirkeingriff steht, und jede der Vielzahl von Schraubenmuttern (117) an der Durchführungsplatte (111) befestigt ist.

14. Verfahren nach Anspruch 11, wobei die vertikale Stange (113) durch eine Drehanordnung (133) gedreht wird, umfassend eine durch einen Drehmotor (125) angetriebene Drehscheibe (134).

15. Verfahren zum Aufnehmen und Sichern eines Wafers unter Verwendung einer Wafer-Handhabungsvorrichtung nach einem der Ansprüche 1 bis 10, umfassend:
Öffnen einer Stiftanordnung (152) durch Heben eines Wafer-Chucks (136) in einer axialen Richtung derart, dass eine Stiftkappe (136) der Stiftanordnung (152) eine Unterseite (106) einer Hauptplatte (104) berührt und eine Feder (156) derart zusammendrückt, dass ein Stift (153) der Stiftanordnung (152) gesenkt wird und ein Übertragungsspalt zwischen einem seitlichen Schenkel (153B) des Stifts (153) und dem Wafer-Chuck (136) maximiert wird; und
Schließen der Stiftanordnung (152) durch Senken des Wafer-Chucks (136) in einer entgegengesetzten axialen Richtung derart, dass die Stiftkappe (156) die Unterseite (106) der Hauptplatte (104) nicht länger berührt und die Feder (156) eine dekomprimierte Position derart einnimmt, dass der Stift (153) gehoben wird und ein zwischen dem seitlichen Schenkel (153B) des Stifts (152) und dem Wafer-Chuck (136) definierter Übertragungsspalt minimiert wird;
wobei ein Wafer (137) eingesetzt oder entfernt werden kann, wenn die Stiftanordnung (152) geöffnet ist, und der Wafer (137) an dem Wafer-Chuck (136) gesichert werden kann, wenn die Stiftanordnung (152) geschlossen ist.

## Revendications

1. Appareil de manipulation de plaquette (100), comprenant :
une plaque de traversée (111) en association fonctionnelle avec une première extrémité (113A) d'une tige verticale (113), dans lequel la plaque de traversée (111) est fonctionnelle pour être levée dans une direction axiale A jusqu'à une position de chargement de plaquette et dans lequel la plaque de traversée (111) est fonctionnelle pour être abaissée dans une direction axiale B opposée jusqu'à une position de traitement de plaquette ;
une plaque principale (104) définissant une face inférieure (106) et une ouverture de plaque principale (109), dans lequel la plaque de traversée (111) est positionnée au-dessus de la plaque principale (104) de telle sorte que la tige verticale (113) s'étend à travers l'ouverture de plaque principale (109) ;
un mandrin de plaquette (136) accouplé à une seconde extrémité (113B) de la tige verticale (113) et positionné en dessous de la plaque principale (104) ; et
une pluralité d'ensembles broche (152) définis annulairement autour du mandrin de plaquette (136), dans lequel chaque ensemble broche (152) de la pluralité d'ensembles broche (152) comprend une branche latérale (153B) ;
dans lequel lorsque la plaque de traversée (111) est levée à la position de chargement de plaquette, un espace de transfert entre le mandrin de plaquette (136) et chaque branche latérale (153B) de chaque ensemble broche (152) de la pluralité d'ensembles broche (152) est maximisé de telle sorte qu'une plaquette électronique (137) peut être insérée entre le mandrin de plaquette (136) et chaque branche latérale (153B) de chaque ensemble broche (152) de la pluralité d'ensembles broche (152) ; et
dans lequel lorsque la plaque de traversée (111) est abaissée à la position de traitement de plaquette, un espace de transfert entre le mandrin de plaquette (136) et chaque branche latérale (153B) de chaque ensemble broche (152) de la pluralité d'ensembles broche (152) est minimisé de telle sorte que la plaquette électronique (137) est fixée au mandrin de plaquette (136) par chaque branche latérale (153B) de chaque ensemble broche (152) de la pluralité d'ensembles broche (152).

2. Appareil de manipulation de plaquette selon la revendication 1, comprenant en outre :
un ensemble de levage (130) en association fonctionnelle avec la plaque de traversée (111), l'ensemble de levage (130) comprenant :
une pluralité de vis allongées (115), chaque vis allongée (115) de la pluralité de vis allongées (115) définissant un filetage externe (118) et dans lequel chaque vis allongée (115) de la pluralité de vis allongées (115) est fonctionnelle pour une rotation autour d'un axe vertical ;
dans lequel chaque vis allongée (115) de la pluralité de vis allongées (115) est accouplée à une poulie de levage (131) respective d'une pluralité de poulies de levage (131) de telle sorte que lorsque chaque poulie de levage (131) est entraînée dans une direction horaire ou antihoraire, chaque vis allongée (115) de la pluralité de vis allongées (115) est mise en rotation dans une direction horaire ou antihoraire ; et
un moteur de levage (119) en association fonctionnelle avec chacune parmi la pluralité de poulies de levage (115), dans lequel le moteur de levage (119) entraîne chaque poulie de levage (115) de la pluralité de poulies de levage (115) dans une direction horaire ou antihoraire ;
dans lequel le filetage externe (118) de chaque vis allongée (115) de la pluralité de vis allongées (115) est fonctionnellement en prise avec la plaque de traversée (111) par un écrou de vis (117) respectif de la pluralité d'écrous de vis (117) de telle sorte qu'à mesure que la pluralité de vis allongées (115) sont mises en rotation dans une direction horaire ou antihoraire, la plaque de traversée (111) est levée dans la direction axiale A ou abaissée dans la direction axiale B.

3. Appareil de manipulation de plaquette selon la revendication 1, comprenant en outre :
un ensemble de rotation (133) en association fonctionnelle avec la tige verticale (113), l'ensemble de rotation (133) comprenant :
une poulie de rotation (134) accouplée à la première extrémité (113A) de la tige verticale (113), dans lequel lorsque la poulie de rotation (134) est entraînée dans une direction horaire ou antihoraire, la tige verticale (113) est mise en rotation dans une direction horaire ou antihoraire ; et
un moteur de rotation (125) en association fonctionnelle avec la poulie de rotation (134), dans lequel le moteur de rotation (125) entraîne la poulie de rotation (134) dans une direction horaire ou antihoraire.

4. Appareil de manipulation de plaquette selon la revendication 1, dans lequel l'ensemble broche (152) comprend en outre :
une broche (153) définissant un corps en forme de L comprenant une branche verticale (153A) et la branche latérale (153B), la branche verticale (153A) comprenant :
une partie supérieure et la partie inférieure, dans lequel la branche latérale s'étend à partir de la partie inférieure de la branche verticale.

5. Appareil de manipulation de plaquette selon la revendication 4, comprenant en outre :
une coiffe de broche (156) définie au niveau de la partie supérieure de la branche verticale (153A) ; et
un ressort (154) gainant la branche verticale (153A) de telle sorte que le ressort (154) est positionné entre la coiffe de broche (156) et le mandrin de plaquette (136) ;
dans lequel le ressort (154) se comprime entre la coiffe de broche (156) et le mandrin de plaquette (136) de telle sorte que l'espace de transfert entre le mandrin de plaquette (136) et chaque branche latérale (153B) de chaque ensemble broche (152) de la pluralité d'ensembles broche (152) est maximisé ; et
dans lequel le ressort (154) se décomprime et pousse la coiffe de broche (156) à l'écart du mandrin de plaquette (136) de telle sorte que l'espace de transfert entre le mandrin de plaquette (136) et chaque branche latérale (153B) de chaque ensemble broche (152) de la pluralité d'ensembles broche (152) est minimisé.

6. Appareil de manipulation de plaquette selon la revendication 5, dans lequel lorsque le mandrin de plaquette (136) et la tige verticale (113) sont levés à la position de chargement de plaquette, la coiffe de broche (156) vient en contact avec une face inférieure (106) de la plaque principale (104) et comprime le ressort (154) de telle sorte que l'espace de transfert est maximisé.

7. Appareil de manipulation de plaquette selon la revendication 6, dans lequel lorsque le mandrin de plaquette (136) et la tige verticale (113) sont abaissés à la position de traitement de plaquette, la coiffe de broche (156) se sépare de la face inférieure (106) de la plaque principale (104) et décomprime le ressort (154) de telle sorte que l'espace de transfert est minimisé.

8. Appareil de manipulation de plaquette selon la revendication 1, dans lequel le mandrin de plaquette (136) est fonctionnel pour venir en prise avec la plaquette (137) et disposer la plaquette (137) au sein d'une chambre de pulvérisation (10) en prise avec l'appareil de manipulation de plaquette (100).

9. Appareil de manipulation de plaquette selon la revendication 1, comprenant en outre :
un capteur photoélectrique (148) fonctionnel pour détecter la présence de la plaquette (137) ; et
un ou plusieurs capteurs (142, 145) fonctionnels pour détecter une position verticale de la plaque de traversée (111) par rapport à la plaque principale (104) ;
dans lequel le capteur photoélectrique (148) et un ou plusieurs capteurs (142, 145) sont en communication fonctionnelle avec un système informatique permettant de déterminer une distance verticale entre la plaque de traversée (111) et la plaque principale (104).

10. Appareil de manipulation de plaquette selon la revendication 1, comprenant en outre une traversée (110), dans lequel la traversée (110) est fonctionnellement en prise avec la première extrémité (113A) de la tige verticale (113) et attachée à la plaque de traversée (111), et dans lequel la traversée (110) permet une rotation de la tige verticale (113) indépendamment de la plaque de traversée (111).

11. Procédé permettant de lever et de mettre en rotation une plaquette à l'aide d'un appareil de manipulation de plaquette selon l'une quelconque des revendications 1 à 10, comprenant :
la mise en rotation de chacune parmi une pluralité de vis allongées (115) ayant des filetages externes (118) dans une direction horaire ou antihoraire, dans lequel la pluralité de vis allongées (115) sont en mise en prise fonctionnelle avec une plaque de traversée (111) de telle sorte qu'à mesure que chacune parmi la pluralité de vis allongées (115) entre en rotation dans une direction horaire ou une direction antihoraire la plaque de traversée (111) est levée dans une direction axiale A ou abaissée dans une direction axiale B ; et
la mise en rotation d'une tige verticale (113) accouplée à un mandrin de plaquette (136) dans une direction horaire ou une direction antihoraire, dans lequel la tige verticale (113) est en mise en prise fonctionnelle avec la plaque de traversée (111) de telle sorte que lorsque la plaque de traversée (111) est levée ou abaissée dans des directions axiales A ou B opposées, la tige verticale (113) et le mandrin de plaquette (136) sont, de façon similaire, levés ou abaissés dans des directions axiales A ou B opposées.

12. Procédé selon la revendication 11, dans lequel chacune parmi la pluralité de vis allongées (115) est mise en rotation par un ensemble de levage (130) comprenant une poulie de levage (131) entraînée par un moteur de levage (119).

13. Procédé selon la revendication 11, dans lequel la plaque de traversée (111) est fonctionnellement en prise avec les filetages externes (118) de chacune parmi la pluralité de vis allongées (115) à l'aide d'un écrou de vis (117) respectif, dans lequel chacun parmi la pluralité d'écrous de vis (117) comprend un filetage interne en mise en prise fonctionnelle avec les filetages externes (118) de la vis allongée (115) respective et chacun parmi la pluralité d'écrous de vis (117) est attaché à la plaque de traversée (111).

14. Procédé selon la revendication 11, dans lequel la tige verticale (113) est mise en rotation par un ensemble de rotation (133) comprenant une poulie de rotation (134) entraînée par un moteur de rotation (125).

15. Procédé permettant de recevoir et de fixer une plaquette à l'aide d'un appareil de manipulation de plaquette selon l'une quelconque des revendications 1 à 10, comprenant :
l'ouverture d'un ensemble broche (152) en levant un mandrin de plaquette (136) dans une direction axiale de telle sorte qu'une coiffe de broche (136) de l'ensemble broche (152) vient en contact avec une face inférieure (106) d'une plaque principale (104) et comprime un ressort (156) de telle sorte qu'une broche (153) de l'ensemble broche (152) est abaissée et qu'un espace de transfert entre une branche latérale (153B) de la broche (153) et le mandrin de plaquette (136) est maximisé ; et
la fermeture de l'ensemble broche (152) en abaissant le mandrin de plaquette (136) dans une direction axiale opposée de telle sorte que la coiffe de broche (156) n'est plus en contact avec la face inférieure (106) de la plaque principale (104) et le ressort (156) prend une position décomprimée de telle sorte que la broche (153) est levée et qu'un espace de transfert défini entre la branche latérale (153B) de la broche (152) et le mandrin de plaquette (136) est minimisé ;
dans lequel une plaquette (137) peut être insérée ou retirée lorsque l'ensemble broche (152) est ouvert et la plaquette (137) peut être fixée au mandrin de plaquette (136) lorsque l'ensemble broche (152) est fermé.
